# EUROPEAN PATENT SPECIFICATION

(11) **EP 3 018 666 B1**
(45) Date of publication and mention of the grant of the patent: **30.12.2020**
(21) Application number: 15192828.0
(22) Date of filing: 03.11.2015
(51) Int. Cl.: H01F 17/06, H01F 27/26, H01F 27/33

(54) **HOLDER AND NOISE CURRENT ABSORBER**
HALTER UND STROMRAUSCHABSORBER
SUPPORT ET ABSORBEUR DE COURANT PARASITE

(30) Priority: 06.11.2014 JP 2014226520
(43) Date of publication of application: 11.05.2016
(73) Proprietor: Kitagawa Industries Co., Ltd., Inazawa-shi, Aichi 492-8446 (JP)
(72) Inventor: KAWAI, Hideharu, Aichi Aichi 492-8446 (JP)
(74) Representative: Littolff, Denis

(56) References cited:
- EP-A1- 0 660 342
- EP-A1- 2 753 161
- JP-A- H08 153 627
- US-A- 5 486 803

## Description

### BACKGROUND

### 1. Technical Field

The present disclosure relates to a holder for a noise current absorber, and to a noise current absorber.

### 2. Description of the Related Art

Noise current absorbers attached around an electric wire for absorbing noise current flowing through the electric wire have been known in the art. One of the noise current absorbers of this type includes a pair of magnetic bodies and a holder. When abutting against each other, the pair of magnetic bodies exhibits a cylindrical shape or an annular shape as a whole. The holder is capable of holding the magnetic bodies in a cylindrical shape.

When the noise current absorber having such a structure is attached to an electric wire, the pair of magnetic bodies exhibiting a cylindrical shape surrounds the electric wire from the outer periphery side. Thus, the pair of magnetic bodies forms a magnetically-closed magnetic circuit, thereby exerting intended noise current absorbing ability (see, for example, Japanese Unexamined Patent Application Publication No. 11-97875).

EP 2 753 161 A1 and JP H08 153627 A address the same kind of technical issue, based on embodiments having however some structural differences with the embodiments of the present invention which will be shown hereinafter in a more detailed way.

### SUMMARY

A holder for a noise current absorber includes: a pair of accommodating units, the accommodating units including respective recesses, each recess being capable of accommodating each of a pair of magnetic bodies, the magnetic bodies exhibiting a cylindrical shape or an annular shape when abutting surfaces of the respective magnetic bodies abut against each other, and the pair of magnetic bodies exhibiting a cylindrical shape or an annular shape in a closed condition where the recesses are arranged to face each other in a state where the recesses accommodate the respective magnetic bodies; at least a pair of engaging portion and an engaged portion provided on each of the pair of accommodating units with the center of the cylindrical shape or the annular shape of the pair of magnetic bodies being interposed between the engaging portion and the engaged portion, the engaging portion and the engaged portion engaging with each other while elastically deforming in the closed condition; and a pair of metal springs provided in the respective recesses, the pair of metal springs urging each magnetic body in a direction toward each abutting surface.

Furthermore, according to the invention, each of the pair of metal springs includes: a flat surface portion having a rectangular shape and arranged on a bottom surface of the recess of the accommodating unit, and a pair of inclined portions continuous with a pair of long sides of the flat surface portion and bent toward the magnetic body; each of the pair of the metal springs is interposed between the magnetic body and the accommodating unit, and is provided at positions, on the bottom surface of the recess, that oppose each other in a direction normal to the abutting surface with the abutting surface interposed therebetween in the closed condition; the flat surface portion includes a pair of holes to be fitted to a pair of protrusions formed on the bottom surface of the recess; the flat surface portion has the rectangular shape with a pair of long sides extending in a direction crossing a central axis of the magnetic body on the bottom surface of the recess; and the pair of inclined portions is continuous with the pair of long sides of the flat surface portion and extends in a direction toward the magnetic body, and is angled toward the magnetic body on the long sides.

### BRIEF DESCRIPTION OF THE DRAWINGS

Figs. 1A to 1G show a configuration of a noise current absorber of an embodiment, Fig. 1A being a front view of the noise current absorber, Fig. 1B being a plan view of the noise current absorber, Fig. 1C being a back view of the noise current absorber, Fig. ID being a left side view of the noise current absorber, Fig. IE being a right side view of the noise current absorber, Fig. IF being a bottom view of the noise current absorber, and Fig. 1G being an upper-right perspective view of the noise current absorber;
Figs. 2A to 2G show a configuration of one of the units of the noise current absorber, Fig. 2A being a front view of the unit, Fig. 2B being a plan view of the unit, Fig. 2C being a back view of the unit, Fig. 2D being a left side view of the unit, Fig. 2E being a right side view of the unit, Fig. 2F being a bottom view of the unit, and Fig. 2G being an upper-right perspective view of the unit;
Figs. 3A and 3B are exploded views showing a configuration of the unit, Fig. 3A being a front view of the unit, and Fig. 3B being a perspective view of the unit;
Figs. 4A to 4C are plan views showing components of the unit;
Fig. 5 is a cross-sectional view taken along line V-V of Fig. 1B; and
Fig. 6 is a cross-sectional view taken along line VI-VI of Fig. 2A.

### DETAILED DESCRIPTION OF THE PREFERRED EMBODIMENTS

In the following detailed description, for purpose of explanation, numerous specific details are set forth in order to provide a thorough understanding of the disclosed embodiments. It will be apparent, however, that one or more embodiments may be practiced without these specific details. In other instances, well-known structures and devices are schematically shown in order to simplify the drawing.

Now, the holder used in the technique of Japanese Unexamined Patent Application Publication No. 11-97875 includes a pair of accommodating units, as follows, that is connected together via a hinge (connecting piece). The pair of accommodating units has respective recesses capable of accommodating respective ones of a pair of magnetic bodies. When the recesses face each other with the magnetic bodies accommodated in the respective recesses, the pair of magnetic bodies exhibits a cylindrical shape. An engaging portion and an engaged portion are provided on the opposite side from the hinge across the abutting surface of the pair of magnetic bodies. The engaging portion and the engaged portion engage with each other in the closed condition where the recesses face each other. Thus, the engaging portion and the engaged portion are capable of maintaining the condition in which the pair of magnetic bodies exhibits a cylindrical shape. Moreover, springs are provided at two respective positions, each on the inner wall surface of each recess, that oppose each other in the direction normal to the abutting surface with the abutting surface being interposed therebetween in the closed condition. Each spring urges the corresponding magnetic body toward the corresponding abutting surface.

Now, Japanese Unexamined Patent Application Publication No. 11-97875 provides no disclosure as to the material of the spring. A holder is used in a place that is exposed to particularly high temperatures and strong vibrations, such as near the engine of an automobile. Therefore, as the spring, it is preferred to use a metal spring that is resistant against heat and vibrations. However, in a case where there is a metal plate such as a chassis nearby, if a metal spring is used as the spring, the capacitive coupling state around the electric wire changes.

On the other hand, with the pair of accommodating units of Japanese Unexamined Patent Application Publication No. 11-97875, a connection is made via a hinge on one side of a pair of springs. A connection is made via the engagement between the engaging portion and the engaged portion on the other side of a pair of springs. On the side where the connection is made via the engagement between the engaging portion and the engaged portion, there is likely a gap between the accommodating units or between the magnetic bodies. Therefore, the positional relationship between the springs is unstable, making it difficult to stably maintain the capacitive coupling state.

It is desirable that one aspect of the present disclosure provides a holder for a noise current absorber using a metal spring. This holder can stably maintain the capacitive coupling state around the electric wire. It is also desirable that another aspect of the present disclosure provides a noise current absorber using the holder.

A holder for a noise current absorber (the holder) according to one embodiment of the present disclosure includes: a pair of accommodating units, the accommodating units including respective recesses, each recess being capable of accommodating each of a pair of magnetic bodies, the magnetic bodies exhibiting a cylindrical shape or an annular shape when abutting surfaces of the respective magnetic bodies abut against each other, and the pair of magnetic bodies exhibiting a cylindrical shape or an annular shape in a closed condition where the recesses are arranged to face each other in a state where the recesses accommodate the respective magnetic bodies; at least a pair of engaging portion and an engaged portion provided on each of the pair of accommodating units with the center of the cylindrical shape or the annular shape of the pair of magnetic bodies being interposed between the engaging portion and the engaged portion, the engaging portion and the engaged portion engaging with each other while elastically deforming in the closed condition; and a pair of metal springs provided in the respective recesses, the pair of metal springs urging each magnetic body in a direction toward each abutting surface.

In this case, at least a pair of an engaging portion and an engaged portion is provided on each of the pair of accommodating units with a center of the cylindrical shape or the annular shape of the pair of magnetic bodies being interposed between the engaging portion and the engaged portion. Also, each of the pair of the metal springs is interposed between the magnetic body and the accommodating unit, and is provided at positions, on the bottom surface of the recess, that oppose each other in a direction normal to the abutting surface with the abutting surface interposed therebetween in the closed condition ; the flat surface portion includes a pair of holes to be fitted to a pair of protrusions formed on the bottom surface of the recess ; the flat surface portion has the rectangular shape with a pair of long sides extending in a direction crossing a central axis of the magnetic body on the bottom surface of the recess ; and the pair of inclined portions is continuous with the pair of long sides of the flat surface portion and extends in a direction toward the magnetic body, and is angled toward the magnetic body on the long sides.

In the prior art documents, EP 2 753 161 shows an embodiment where there is no provision of a respective separate metal springs having the above shape and orientation in each of the accommodating unit on a bottom surface portion of the respective recesses. Besides, JP H08 153627 describes a specific shape of metal springs provided in an accommodating unit for magnetic bodies of a noise current absorbing equipment, with a curved shape however quite different from the one of the present invention, working furthermore rather differently.

The engaging portion and the engaged portion engage with each other when the recesses abut against each other in a closed condition where the pair of magnetic bodies exhibits a cylindrical shape (or annular shape). Thus, it is possible to maintain the condition where the pair of magnetic bodies exhibits a cylindrical shape (or annular shape). Therefore, on either side of the accommodating units with respect to the pair of metal springs provided on the recesses and urging the magnetic bodies in the direction toward the abutting surface, each of the pair of accommodating units is connected together via the engagement between the engaging portion and the engaged portion. This stabilizes the positional relationship such as the parallelism between the metal springs. Therefore, it is possible to stably maintain the capacitive coupling state around the electric wire.

Note that the pair of metal springs may be provided at positions on the inner wall surfaces of the recesses opposing each other in a direction normal to the abutting surface with the abutting surface being interposed therebetween in the closed condition. Moreover, each engaging portion may be formed in a hook shape projecting in a direction perpendicular to the abutting surface. Each engaged portion may be formed as a gate-shaped stopper frame with which the hook-shaped engaging portion engages.

In such a case, in the closed condition, each of the pair of metal springs opposes each other, with the abutting surface located therebetween in the direction normal to the abutting surface. Moreover, in a case where the engaging portion and the engaged portion have such a configuration as described above, gaps occurring between the accommodating units or between the magnetic bodies are similar to each other on the opposite sides of the abutting surface. Therefore, the advantage obtained because the accommodating units are connected together via the engagement between the engaging portion and the engaged portion on opposite sides of the abutting surface will be even more remarkable.

The pair of metal springs may be formed by a material having resistivity of 10⁻⁷ Ω·m or more. If the resistivity of the pair of metal springs is low, the metal springs may possibly act as a radiation noise antenna due to the electromagnetic noise coming from, for example, the metal plate to which the noise current absorber is attached. In contrast, if the pair of metal springs has the resistivity as described above, it is possible to inhibit the action of the metal springs as a radiation noise antenna.

Each of the pair of accommodating units may have the same shape. Moreover, each of the pair of metal springs may have the same shape. In such a case, the pair of accommodating units is in a mutually-opposing relation, and the pair of metal springs is in a mutually-opposing relation. Therefore, it is possible to even more stably maintain the capacitive coupling state around the electric wire. Moreover, the same mold, or the like, can be commonly used for producing the pair of accommodating units or the pair of metal springs. Moreover, when distributed, they do not need to be distinguished from each other. Therefore, it is possible to reduce the manufacturing cost and the cost of distribution of the holder. Now, regarding the same shape, shapes are regarded as being the same even with some manufacturing errors (this similarly applies hereinbelow).

The holder may further include a support provided on each outer periphery of the pair of accommodating units, the support being used for arranging the pair of accommodating units and the pair of magnetic bodies on a surface parallel to the abutting surface. In such a case, if the holder is arranged on (supported by) a surface such as a metal plate via the support therebetween, the pair of abutting surfaces is arranged parallel to the surface such as a metal plate. Therefore, even if any one of the pair of accommodating units is arranged on a surface such as a metal plate via the support, the two abutting surfaces will be arranged similarly, and the pair of metal springs will also be arranged similarly. Specifically, even when the holder arranged on the metal plate is rotated by 180°, the abutting surfaces are positioned at the same height before and after the rotation, and each of the pair of metal springs is at the same upper position or the same lower position before and after the rotation although being positionally replaced with each other. Thus, it is possible to even more stably maintain the capacitive coupling state around the electric wire.

More precisely, as a support, the holder may include a bottom surface of the accommodating unit, the bottom surface having a rectangular shape as generally seen in a plan view, and the bottom surface having a rectangular shape with a pair of long sides parallel to a direction of a central axis of the magnetic body on the outer periphery of the holder; the holder also comprises a pair of ribs formed to be spaced apart from each other along each long side of the bottom surface and projecting along an extension plane of the bottom surface, the pair of ribs being spaced apart from each other in a front-rear direction with the bottom surface interposed therebetween, and being adjacent to each of the pair of long sides of the bottom surface facing each other, the pair of ribs extending along the extension plane in a direction opposite to each other from the pair of long sides of the bottom surface.

Also, each of the pair of metal springs may include a pair of folded-back portions formed by folding back tip portions of the inclined portions in a direction away from the magnetic body.

A noise current absorber according to one embodiment of the present disclosure (the noise current absorber) includes: a pair of magnetic bodies, the magnetic bodies exhibiting a cylindrical shape or an annular shape when abutting surfaces of the respective magnetic bodies abut against each other; a pair of accommodating units, the accommodating units including respective recesses, each recess being capable of accommodating each of a pair of magnetic bodies, and the pair of magnetic bodies exhibiting a cylindrical shape or an annular shape in a closed condition where the recesses are arranged to face each other in a state where the recesses accommodate the respective magnetic bodies; at least a pair of engaging portion and an engaged portion provided on each of the pair of accommodating units with the center of the cylindrical shape or the annular shape of the pair of magnetic bodies being interposed between the engaging portion and the engaged portion, the engaging portion and the engaged portion engaging with each other while elastically deforming in the closed condition; and a pair of metal springs provided in each recess, the pair of metal springs urging each magnetic body in a direction toward each abutting surface.

In the embodiment of the invention, each of the pair of metal springs includes a flat surface portion having a rectangular shape and arranged on a bottom surface of the recess of the accommodating unit, and a pair of inclined portions continuous with a pair of long sides of the flat surface portion and bent toward the magnetic body ; each of the pair of the metal springs is interposed between the magnetic body and the accommodating unit, and is provided at positions, on the bottom surface of the respective recesses, that oppose each other in a direction normal to the abutting surface with the abutting surface interposed therebetween in the closed condition ; also, the flat surface portion includes a pair of holes to be fitted to a pair of protrusions formed on the bottom surface of the recess, the flat surface portion having the rectangular shape with a pair of long sides extending in a direction crossing a central axis of the magnetic body on the bottom surface of the recess, and the pair of inclined portions being continuous with the pair of long sides of the flat surface portion and extends in a direction toward the magnetic body, and being angled toward the magnetic body on the long sides.

The noise current absorber has a configuration similar to that of the holder described above. Therefore, the noise current absorber can stably maintain the capacitive coupling state around the electric wire. Note that the pair of accommodating units may have the same shape, the pair of magnetic bodies accommodated in the pair of accommodating units may have the same shape, and the pair of metal springs accommodated in the pair of accommodating units may have the same shape. In such a case, each of the pair of accommodating units has the same shape, each of the pair of magnetic bodies has the same shape, and each of the pair of metal springs has the same shape. Therefore, it is possible to even more stably maintain the capacitive coupling state around the electric wire. Moreover, the same mold, or the like, can be commonly used for producing the pair of accommodating units, the pair of magnetic bodies or the pair of metal springs. Moreover, when distributed, they do not need to be distinguished from each other. Therefore, it is possible to reduce the manufacturing cost and the cost of distribution of the noise current absorber.

The noise current absorber may further include a support provided on each outer periphery of the pair of accommodating units, the support being used for arranging the pair of accommodating units and the pair of magnetic bodies on a flat surface. In such a case, the abutment portions of the pair of magnetic bodies to be abutted against the respective metal springs may be each formed as a flat surface approximately parallel to the flat surface. In such a case, if the noise current absorber is arranged on a flat surface such as a metal plate via a support therebetween, the abutment portion of each magnetic body is disposed approximately parallel to the metal plate, or the like. As the pair of metal springs is pressed against the respective abutment portions of the magnetic bodies, the pair of metal springs is disposed approximately parallel to the abutment portions. Therefore, each of the metal springs is disposed approximately parallel to a flat surface such as a metal plate. Therefore, it is possible to even more stably maintain the capacitive coupling state around the electric wire.

Next, an embodiment of the present disclosure will be described with reference to the drawings. Note that an up-down direction, a left-right direction and a front-rear direction are defined as necessary in the following description. Note however that these directions are defined only for the purpose of concisely describing the positional relationship between various parts of the noise current absorber and the holder. When the noise current absorber and the holder are used in practice, the noise current absorber and the holder may each be orientated in any direction. For example, the noise current absorber and the holder may be used in such a position that the up-down direction shown in the figures does not coincide with the vertical direction in relation to the gravity.

### [Configuration of embodiment]

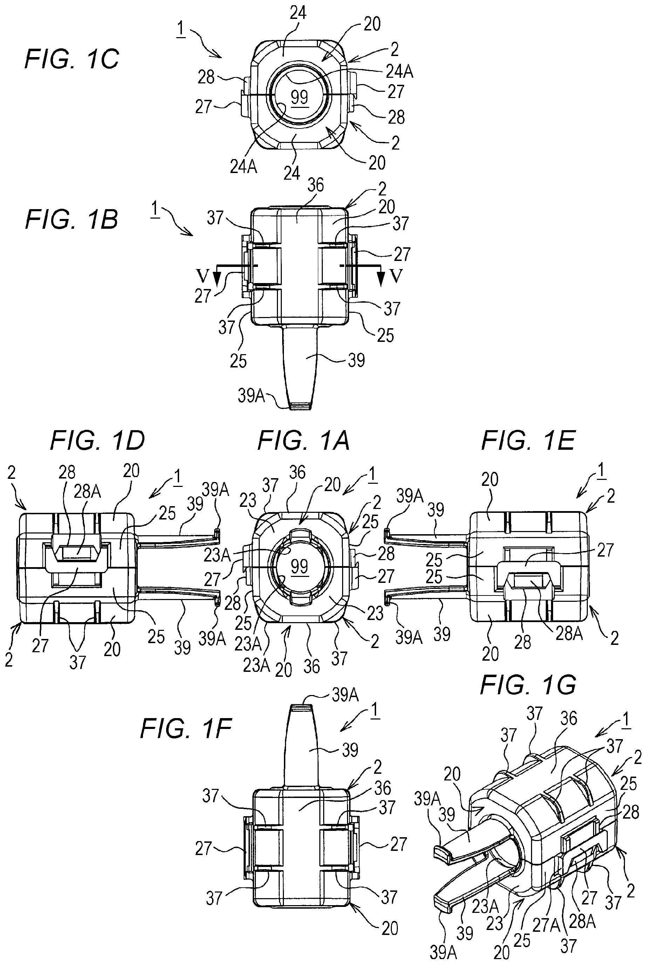

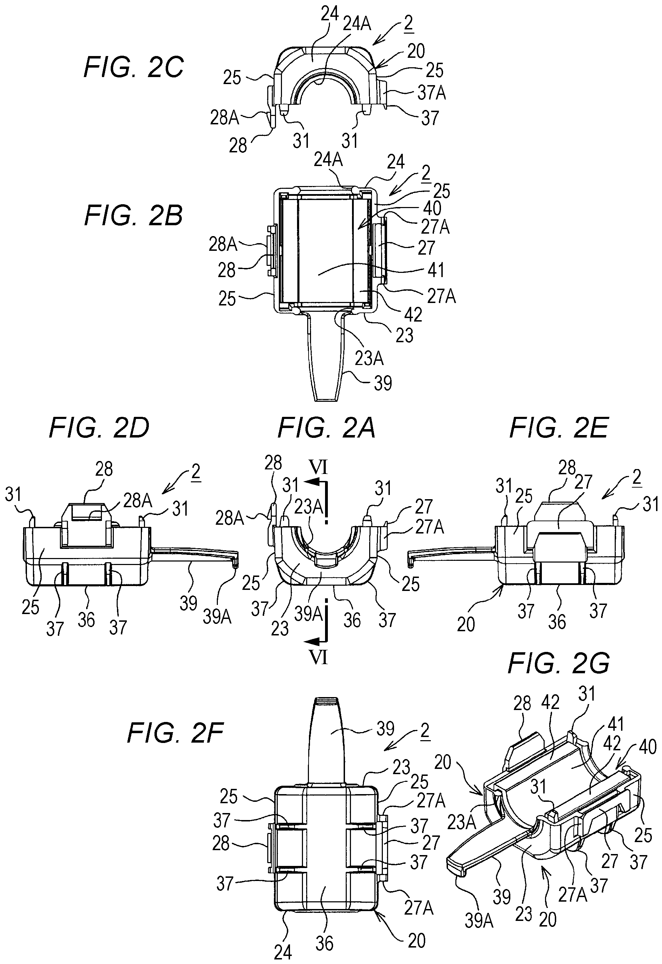

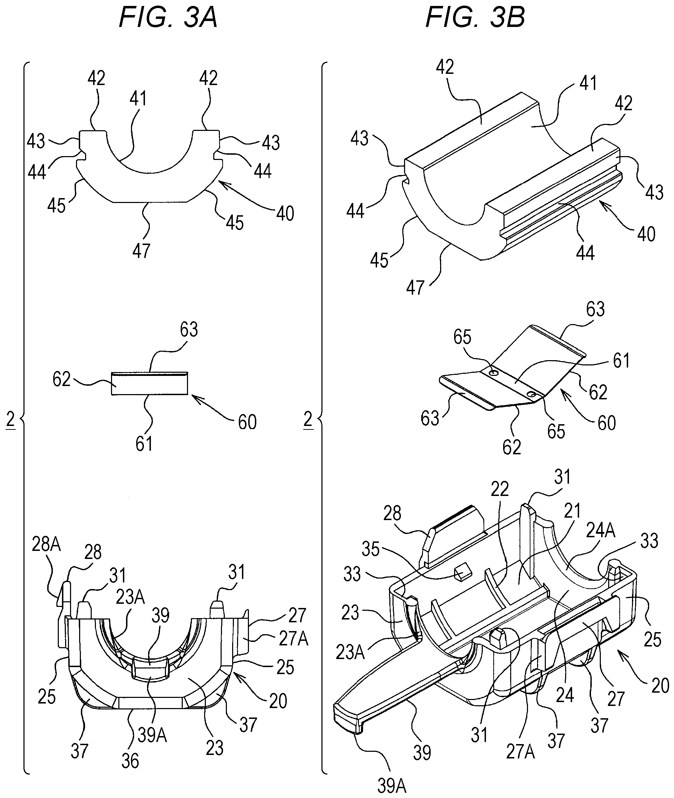

A noise current absorber 1 shown in Figs. 1A to 1G is attached to an outer periphery of an electric wire (not shown) in order to absorb noise current flowing through the electric wire. The noise current absorber 1 includes a pair of units 2 and 2 having the same shape (with some manufacturing errors (this similarly applies hereinbelow)), which is assembled together. As shown in Figs. 2A to 2G, 3A, and 3B, each unit 2 includes a resin component 20 (an example of the accommodating unit), a magnetic body 40, and a metal spring 60.

The magnetic bodies 40 are formed in the same shape. Each magnetic body 40 has a semi-cylindrical shape. The magnetic bodies 40 have such a shape that when the respective abutting surfaces 42 thereof face each other, the magnetic bodies 40, as a whole, exhibit a cylindrical shape. Note that the magnetic bodies 40 may have such a shape that when the respective abutting surfaces 42 thereof abut against each other, the magnetic bodies 40, as a whole, form an annular shape. The cylindrical shape and the annular shape as used herein may be referred to collectively as the cylindrical shape.

An inner surface 41 of each magnetic body 40 has a cylindrical surface. When the abutting surfaces 42 abut against each other, the pair of magnetic bodies 40 is assembled together into a cylindrical shape. Thus, a columnar through hole 99 is formed. The pair of units 2 and 2 is assembled together so that an electric wire fits in the through hole 99. When one unit 2 (including the resin component 20, the magnetic body 40 and the metal spring 60) is rotated by 180 degrees about the central axis of the through hole 99, the shape of the one unit 2 coincides with the shape of the other unit 2. Note that in the following description, each unit 2 may be described by defining the direction toward the abutting surface 42 as upward, and the direction of the central axis of the through hole 99 as the front-rear direction.

As shown in Figs. 3A and 3B, the outer periphery surface of each magnetic body 40 extending in the front-rear direction includes a side surface 43, a cylindrical surface 45, a bottom surface 47, the cylindrical surface 45 and a side surface 43, about the central axis of the through hole 99, starting from the outer edge of one abutting surface 42 to the outer edge of the other abutting surface 42. The side surfaces 43 are provided so as to be continuous with the outer edges of the pair of abutting surfaces 42 so that the side surfaces 43 are at the right angle with the abutting surfaces 42. A groove 44 is formed in the side surface 43. The groove 44 is engraved so that the cross section thereof extends from the side surface 43 toward the inner surface 41. The groove 44 runs through the magnetic body 40 in the front-rear direction.

The edges of the side surfaces 43 and 43 that are away from the abutting surfaces 42 and 42 are provided so as to be continuous with the bottom surface 47 via the cylindrical surfaces 45 and 45. The bottom surface 47 is parallel to the abutting surfaces 42 and 42. The magnetic body 40 is configured to have a predetermined thickness between the bottom surface 47 and the inner surface 41.

As shown in Fig. 3B, each resin component 20 has a recess 21. The recess 21 accommodates one magnetic body 40 from the side of the bottom surface 47. The recess 21 includes a rib 22 formed thereon for supporting the bottom surface 47 and the pair of cylindrical surfaces 45 and 45 of the magnetic body 40. A semi-circular cut-out 23A for allowing an electric wire to pass through is formed on a wall surface 23 provided on one side of the recess 21 in the front-rear direction. A semi-circular cut-out 24A for allowing an electric wire to pass through is similarly formed on the other wall surface 24 of the recess 21. The resin components 20 are formed so that the pair of magnetic bodies 40 exhibits a cylindrical shape (or an annular shape) in the closed condition where the recesses 21 face each other with the magnetic body 40 accommodated in each recess 21.

An engaged portion 27 and an engaging portion 28 are formed on the outer surface of each of the side walls 25 and 25 of each resin component 20 supporting each of the side surfaces 43 and 43 of the magnetic body 40 from the outer side. The engaged portion 27 and the engaging portion 28 engage with each other when the recesses 21 and 21 of the pair of resin components 20 and 20 face each other, and more specifically, when the abutting surfaces 42 and 42 abut each other in a case where the magnetic bodies 40 are accommodated in the respective resin components 20, and when opening surfaces of the respective resin components 20 abut each other in a case where the magnetic bodies 40 are not accommodated therein (hereinafter referred to as "in the closed condition"). The engaged portion 27 is provided at a position apart from the side wall 25 with leg portions 27A at the opposite ends in the front-rear direction interposed therebetween. The engaged portion 27 as a whole is gate-shaped. The engaging portion 28 is projecting upward so that it can be inserted into the gap between the engaged portion 27 and the side wall 25 of the other resin component 20. A hook 28A having a claw-shaped cross section is formed on the engaging portion 28. That is, the engaging portion 28 is formed in a hook shape projecting in a direction perpendicular to the abutting surface 42. The hook 28A is inserted into the gap and engaged with the engaged portion 27. That is, the engaged portion 27 is formed as a gate-shaped stopper frame with which the hook-shaped engaging portion 28 engages. A pair of the engaged portion 27 and the engaging portion 28 is provided on each of the pair of resin components 20 so that the center of the cylindrical (or annular) shape of the pair of magnetic bodies 40 is located between the engaged portion 27 and the engaging portion 28.

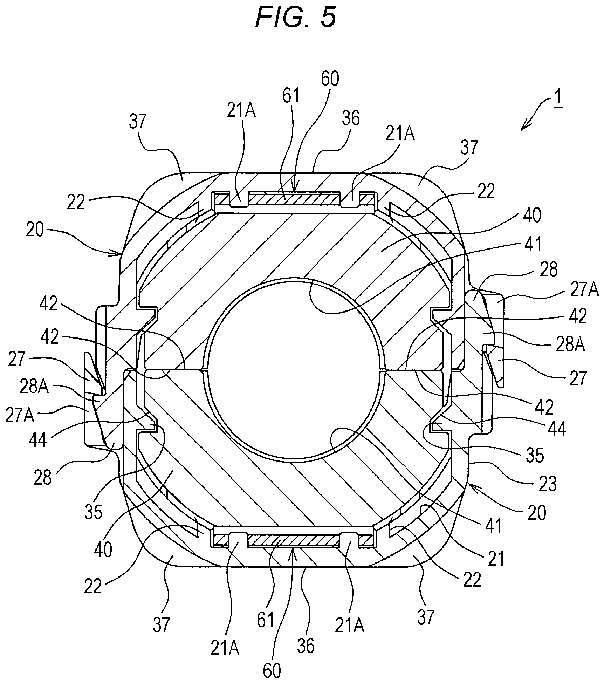

Therefore, the hook 28A of the engaging portion 28 formed on one resin component 20 engages with the engaged portion 27 formed on the other resin component 20 while elastically deforming when the recesses 21 and 21 are in the closed condition. Also, the hook 28A of the engaging portion 28 formed on the other resin component 20 engages with the engaged portion 27 formed on the one resin component 20 while elastically deforming. Thus, the pair of resin components 20 and 20 is secured with each other. As a result, the magnetic bodies 40 and 40 accommodated in the respective recesses 21 and 21 are held by the resin components 20 while the magnetic bodies 40 and 40 exhibit a cylindrical shape. Note that as will be illustrated in detail in Fig. 5 to be discussed later, the part of the engaged portion 27 to contact with the hook 28A is formed to have a claw-shaped cross section so that the part of the engaged portion 27 can be easily engaged with the hook 28A.

Protrusions 31 and 31 projecting upward from the inside of the respective wall surfaces 23 and 24 of each resin component 20 fit in respective recesses 33 and 33 formed on the inside of the respective wall surfaces 23 and 24 of the other resin component 20 when the recesses 21 and 21 are in the closed condition. Thus, the pair of resin components 20 is even more excellently secured with each other. Note that the protrusions 31 and the recesses 33 are formed outside the cut-out 23A or 24A. Protrusions 35 are formed at positions on the recess 21 of the resin component 20 opposing the grooves 44 of the magnetic body 40. When the magnetic body 40 is inserted in the recess 21, the protrusions 35 engage with the grooves 44 of the magnetic body 40. This inhibits the magnetic body 40 from coming off the recess 21.

The metal spring 60 is located between the magnetic body 40 and the resin component 20. A pair of metal springs 60 is provided, each on the recess 21 of the corresponding resin component 20, urging the magnetic body 40 in the direction toward the abutting surface 42 of the magnetic body 40 (in the direction normal to the abutting surface 42). The pair of metal springs 60 is provided at positions, each on the inner wall surface of the recess 21, that oppose each other in the direction normal to the abutting surface 42 with the abutting surface 42 being interposed therebetween in the closed condition.

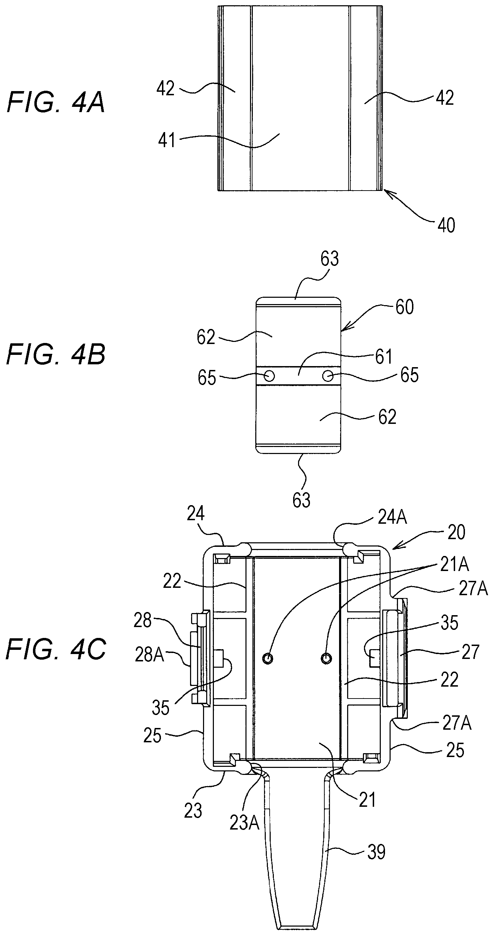

The metal spring 60 is formed by a metal (e.g., SUS) having resistivity of 10⁻⁷ Ω·m or more, for example. As shown in Figs. 3B and 4B, the metal spring 60 includes a flat surface portion 61, a pair of inclined portions 62, and a pair of folded-back portions 63. The flat surface portion 61 includes holes 65 and 65 to be fitted to a pair of protrusions 21A and 21A (see Fig. 4C) formed on the bottom surface of the recess 21. The flat surface portion 61 has a rectangular shape that is elongated in the left-right direction along the longitudinal axis of the flat surface portion 61. The pair of inclined portions 62 is continuous with the pair of long sides of the flat surface portion 61 and is bent toward the magnetic body 40. The folded-back portions 63 and 63 are formed by folding back tip portions of the inclined portions 62 and 62 in a direction away from the magnetic body 40.

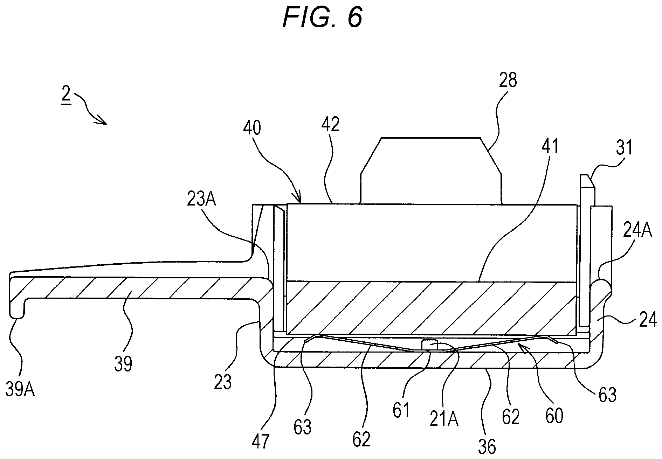

Therefore, when the magnetic body 40 is inserted in the recess 21, and the grooves 44 engage with the protrusions 35, the magnetic body 40 deforms the metal spring 60 as shown in Fig. 6. Therefore, the magnetic body 40 is urged upward by the metal spring 60. Note that the grooves 44 and the protrusions 35 engage with each other with an adequate gap therebetween so that such an urging force can act suitably. Therefore, in the closed condition where the pair of engaging portions 28 and 28 and the pair of engaged portions 27 and 27 are engaged with each other, the abutting surfaces 42 of the respective magnetic bodies 40 are suitably pressed against each other as shown in Fig. 5.

On the other hand, a bottom surface 36 of the resin component 20, which is disposed outside the bottom surface 47 of the magnetic body 40 and the metal spring 60, has a rectangular shape with its long sides parallel to the front-rear direction as generally seen in a plan view, as shown in Figs. 1A, 1B, IF and 1G. Ribs 37 are formed on the outer periphery of the resin component 20 at positions adjacent to the long sides of the bottom surface 36. The ribs 37 project along the extension plane of the bottom surface 36. A pair of ribs 37 is formed to be spaced apart from each other in the front-rear direction along each long side of the bottom surface 36. Therefore, a band (not shown) can be wound around the outer periphery of the noise current absorber 1 between each of the pair of ribs 37, 37.

Moreover, projections 39 and 39, which are projecting outward in the front-rear direction, are formed on the respective wall surfaces 23 and 23 of the pair of resin components 20 and 20. The projection 39 is used for securing, with a tape, the noise current absorber 1 onto an automobile harness or a metal frame such as a frame, a metal plate or a chassis of an automobile. A tip 39A of the projection 39 is bent outward (away from the extension plane of the abutting surface 42). As a result, the projection 39 can be easily secured onto the metal frame or the harness.

### [Effects of embodiment]

When the noise current absorber 1 having such a configuration is attached to an electric wire, the pair of magnetic bodies 40 exhibiting a cylindrical shape surrounds the electric wire from the outer periphery side. Thus, the pair of magnetic bodies 40 forms a magnetically-closed magnetic circuit. As a result, the noise current absorber 1 can exert an intended noise current absorbing ability.

In the present embodiment, a pair of the engaging portion 28 and the engaged portion 27 is provided on each resin component 20 so that the abutting surface 42 of the magnetic body 40 is located between the engaging portion 28 and the engaged portion 27 in the left-right direction. In the closed condition where the recesses 21 face each other and the pair of magnetic bodies 40 exhibits a cylindrical shape, the engaging portion 28 and the engaged portion 27 engage with each other. Thus, it is possible to maintain the position where the pair of magnetic bodies 40 exhibits a cylindrical shape.

Therefore, on either side of the resin components 20 with the abutting surface 42 lodated therebetween in the left-right direction, with respect to the metal spring 60 provided on each recess 21 and urging the magnetic body 40 in the direction toward the abutting surface 42, each of the pair of resin components 20 is connected together via the engagement between the engaging portion 28 and the engaged portion 27. This stabilizes the positional relationship such as the parallelism between the metal springs 60. In the closed condition, the pair of metal springs 60 opposes each other with the abutting surfaces 42 of the magnetic bodies 40 interposed therebetween, and are arranged in parallel to each other. Therefore, in the present embodiment, it is possible to stably maintain the capacitive coupling state around the electric wire.

The units 2 have the same shape. Therefore, the present embodiment provides the following effect. That is, the pair of resin components 20, the pair of magnetic bodies 40 and the pair of metal springs 60 each have the same or a similar shape with each other. Thus, it is possible to even more stably maintain the capacitive coupling state around the electric wire. Moreover, the same mold, or the like, can be commonly used for producing the pair of resin components 20, the pair of magnetic bodies 40 or the pair of metal springs 60. Moreover, when distributed, one unit 2 and the other unit 2 do not need to be distinguished from each other as with male and female parts. Therefore, with the noise current absorber 1 of the present embodiment, it is possible to desirably reduce the manufacturing cost and the cost of distribution.

Moreover, the bottom surface 36 of the resin component 20 is disposed outside the bottom surface 47 of the magnetic body 40 and the metal spring 60. The bottom surface 36 has an approximately flat shape. The ribs 37 projecting along the plane of the bottom surface 36 are formed at adjacent positions along each long side of the bottom surface 36. The bottom surface 36 and the ribs 37 are provided on each outer periphery of the pair of resin components 20, and are used for arranging the pair of resin components 20 and the pair of magnetic bodies 40 to a surface that is parallel to the abutting surface 42 of the magnetic body 40. As the noise current absorber 1 is arranged on a surface such as a metal plate via the bottom surface 36 and the ribs 37 (both being an example of the support), the abutting surface 42 of the pair of magnetic bodies 40 and the pair of metal springs 60 (particularly the flat surface portion 61) are arranged parallel to a surface such as a metal plate. Therefore, the two abutting surfaces 42 are arranged similarly, whichever of the pair of resin components 20 is arranged on a surface such as a metal plate as described above. Moreover, the pair of metal springs 60 is arranged similarly. Specifically, even when the noise current absorber 1 arranged on the metal plate is rotated by 180°, the abutting surfaces 42 are positioned at the same height before and after the rotation, and each of the pair of metal springs 60 is at the same upper position or the same lower position before and after the rotation although being positionally replaced with each other. Therefore, in the present embodiment, it is possible to even more stably maintain the capacitive coupling state around the electric wire.

The bottom surfaces 47 and 47, as abutment portions of the magnetic bodies 40 and 40 to be abutting against the metal springs 60 and 60, are also disposed approximately parallel to a surface such as a metal plate arranged (supported) by the bottom surface 36 and the ribs 37. As the pair of metal springs 60 and 60 is pressed against the bottom surfaces 47 and 47, the pair of metal springs 60 and 60 is disposed approximately parallel to the bottom surfaces 47 and 47. Therefore, the pair of metal springs 60 and 60 is disposed approximately parallel to the surface such as a metal plate. Thus, it is possible to even more stably maintain the capacitive coupling state around the electric wire.

Moreover, the pair of metal springs 60 is formed by a material having resistivity of 10⁻⁷ Ω · m or more. Thus, it is possible to inhibit the action of the metal springs 60 as a radiation noise antenna. That is, if the resistivity of the metal spring 60 is low, the metal springs 60 may possibly act as a radiation noise antenna due to the electromagnetic noise coming from, for example, the metal plate to which the noise current absorber 1 is attached. In contrast, if the pair of metal springs 60 has such resistivity as described above, it is possible to inhibit the action of the metal springs 60 as a radiation noise antenna.

Note that in the embodiment described above, the pair of resin components 20 and the pair of metal springs 60 correspond to a holder.

### [Other embodiments]

The technique of the present disclosure is not limited to the embodiment described above, but can be carried out in various other embodiments without departing from the gist of the present disclosure. For example, in addition to the configuration described above, various configurations may be employed as the configuration of the engaging portion and the engaged portion. There may be a plurality of pairs of engaging portions and engaged portions. One resin component may be provided with a pair (or pairs) of engaging portions, while the other resin component is provided with a pair (or pairs) of engaged portions to be engaged with the engaging portions. Moreover, various changes may be made to the shapes of the magnetic bodies, the accommodating units and the metal springs within the scope defined by the accompanying claims. In addition to the noise current absorber described above, the technique of the present disclosure may be implemented in various other embodiments such as an electronic device including the noise current absorber as its component, a noise current absorbing method, and the like.

Note that in the present specification, terms referring to shapes and conditions such as "cylindrical", "columnar", "rectangular", "flat surface", "center", "parallel", "perpendicular", "right angle", "same", etc., are not limited to those shapes and conditions in their strict senses, but also include similar shapes and conditions, slightly off of those conditions, as long as the resultant functions and effects are not lost.

The foregoing detailed description has been presented for the purposes of illustration and description. Many modifications and variations are possible in light of the above teaching. It is not intended to be exhaustive or to limit the subject matter described herein to the precise form disclosed. Although the subject matter has been described in language specific to structural features and/or methodological acts, it is to be understood that the subject matter defined in the appended claims is not necessarily limited to the specific features or acts described above. Rather, the specific features and acts described above are disclosed as example forms of implementing the claims appended hereto.

## Claims

1. A holder (20, 60) for a noise current absorber (1), comprising:
a pair of accommodating units (20), the accommodating units including respective recesses (21), each recess (21) being capable of accommodating each of a pair of magnetic bodies (40), the magnetic bodies (40) exhibiting a cylindrical shape or an annular shape when abutting surfaces (42) of the respective magnetic bodies (40) abut against each other, and the pair of magnetic bodies (40) exhibiting a cylindrical shape or an annular shape in a closed condition where the recesses (21) are arranged to face each other in a state where the recesses (21) accommodate the respective magnetic bodies (40);
at least a pair of engaging portion (28) and an engaged portion (27) provided on each of the pair of accommodating units (20) with the center of the cylindrical shape or the annular shape of the pair of magnetic bodies (40) being interposed between the engaging portion (28) and the engaged portion (27), the engaging portion (28) and the engaged portion (27) engaging with each other while elastically deforming in the closed condition; and
a pair of metal springs (60) provided in the respective recesses (21), the pair of metal springs (60) urging each magnetic body (40) in a direction toward each abutting surface (42),
wherein_each of the pair of metal springs (60) includes:
a flat surface portion (61) having a rectangular shape and arranged on a bottom surface of the recess (21) of the accommodating unit (20), and a pair of inclined portions (62) continuous with a pair of long sides of the flat surface portion (61) and bent toward the magnetic body (40),
wherein each of the pair of the metal springs (60) is interposed between the magnetic body (40) and the accommodating unit (20), and is provided at positions, on the bottom surface of the recess (21), that oppose each other in a direction normal to the abutting surface (42) with the abutting surface (42) interposed therebetween in the closed condition,
wherein the flat surface portion (61) includes a pair of holes (65) to be fitted to a pair of protrusions (21A) formed on the bottom surface of the recess (21),
wherein the flat surface portion (61) has the rectangular shape with a pair of long sides extending in a direction crossing a central axis of the magnetic body (40) on the bottom surface of the recess (21), and
wherein the pair of inclined portions (62) is continuous with the pair of long sides of the flat surface portion (61) and extends in a direction toward the magnetic body, and is angled toward the magnetic body (40) on the long sides.

2. The holder (20, 60) for a noise current absorber (1) according to claim 1, wherein
each engaging portion (28) is formed in a hook shape projecting in a direction perpendicular to the abutting surface (42), and
each engaged portion (27) is formed as a gate-shaped stopper frame with which the hook-shaped engaging portion (28) engages.

3. The holder (20, 60) for a noise current absorber (1) according to any one of claims 1 to 2, wherein
the pair of metal springs (60) is formed by a material having resistivity of 10⁻⁷ Ω·m or more.

4. The holder (20, 60) for a noise current absorber (1) according to any one of claims 1 to 3, wherein
the pair of accommodating units (20) has the same shape, and
the pair of metal springs (60) has the same shape.

5. The holder (20, 60) for a noise current absorber (1) according to any one of claims 1 to 4, further comprising
a support (36, 37) provided on each outer periphery of the pair of accommodating units (20), the support (36, 37) being used for arranging the pair of accommodating units (20) and the pair of magnetic bodies (40) on a surface parallel to the abutting surface (42).

6. The holder (20, 60) for a noise current absorber (1) according to claim 5, comprising, as the support (36, 37),
a bottom surface (36) of the accommodating unit (20), the bottom surface (36) having a rectangular shape as generally seen in a plan view, and the bottom surface (36) having a rectangular shape with a pair of long sides parallel to a direction of a central axis of the magnetic body (40) on the outer periphery of the holder (20),
wherein the holder (20,60) comprises a pair of ribs (37) formed to be spaced apart from each other along each long side of the bottom surface (36) and projecting along an extension plane of the bottom surface (36),
wherein the pair of ribs (37) is spaced apart from each other in a front-rear direction with the bottom surface (36) interposed therebetween, and are adjacent to each of the pair of long sides of the bottom surface (36) facing each other,
wherein the pair of ribs (37) extend along the extension plane in a direction opposite to each other from the pair of long sides of the bottom surface (36).

7. The holder (20, 60) for a noise current absorber (1) according to one of claims 1 to 6, wherein
each of the pair of metal springs (60) includes a pair of folded-back portions (63) formed by folding back tip portions of the inclined portions (62) in a direction away from the magnetic body (40).

8. A noise current absorber (1) comprising:
a pair of magnetic bodies (40), the magnetic bodies (40) exhibiting a cylindrical shape or an annular shape when abutting surfaces (42) of the respective magnetic bodies (40) abut against each other;
a pair of accommodating units (20), the accommodating units including respective recesses (21), each recess (21) being capable of accommodating each of a pair of magnetic bodies (40), and the pair of magnetic bodies (40) exhibiting a cylindrical shape or an annular shape in a closed condition where the recesses (21) are arranged to face each other in a state where the recesses (21) accommodate the respective magnetic bodies (40);
at least a pair of engaging portion (28) and an engaged portion (27) provided on each of the pair of accommodating units (20) with the center of the cylindrical shape or the annular shape of the pair of magnetic bodies (40) being interposed between the engaging portion (28) and the engaged portion (27), the engaging portion (28) and the engaged portion (27) engaging with each other while elastically deforming in the closed condition; and
a pair of metal springs (60) provided in each recess (21), the pair of metal springs (60) urging each magnetic body (40) in a direction toward each abutting surface (42),
wherein each of the pair of metal springs (60) includes a flat surface portion (61) having a rectangular shape and arranged on a bottom surface of the recess (21) of the accommodating unit (20), and a pair of inclined portions (62) continuous with a pair of long sides of the flat surface portion (61) and bent toward the magnetic body (40),
wherein each of the pair of the metal springs (60) is interposed between the magnetic body (40) and the accommodating unit (20), and is provided at positions, on the bottom surface of the respective recesses (21), that oppose each other in a direction normal to the abutting surface (42) with the abutting surface (42) interposed therebetween in the closed condition,
wherein the flat surface portion (61) includes a pair of holes (65) to be fitted to a pair of protrusions (21A) formed on the bottom surface of the recess (21),
wherein the flat surface portion (61) has the rectangular shape with a pair of long sides extending in a direction crossing a central axis of the magnetic body (40) on the bottom surface of the recess (21), and
wherein the pair of inclined portions (62) is continuous with the pair of long sides of the flat surface portion (61) and extends in a direction toward the magnetic body, and is angled toward the magnetic body (40) on the long sides.

9. The noise current absorber (1) according to claim 8, wherein
the pair of accommodating units (20) has the same shape,
the pair of magnetic bodies (40) accommodated in the pair of accommodating units (20) has the same shape, and
the pair of metal springs (60) accommodated in the pair of accommodating units (20) has the same shape.

10. The noise current absorber (1) according to claim 8 or 9, further comprising
a support (36, 37) provided on each outer periphery of the pair of accommodating units (20), the support (36, 37) being used for arranging the pair of accommodating units (20) and the pair of magnetic bodies (40) on a flat surface, wherein
abutment portions of the pair of magnetic bodies (40) that are abutted against the respective metal springs (60) are each formed as a flat surface approximately parallel to the flat surface.

11. The noise current absorber (1) according to any one of claims 8 to 10, wherein
the pair of magnetic bodies (40) each has a groove (44) in a side surface thereof, and
the pair of accommodating units (20) each includes a protrusion (35) formed at a position on the recess (21) opposing the groove (44) of the magnetic body (40).

## Patentansprüche

1. Halter (20, 60) für einen Stromrauschabsorber (1), umfassend:
ein Paar Aufnahmeeinheiten (20), wobei die Aufnahmeeinheiten jeweilige Aussparungen (21) einschließen, wobei jede Aussparung (21) dazu in der Lage ist, jeden eines Paars magnetischer Körper (40) aufzunehmen, wobei die magnetischen Körper (40) eine zylindrische Form oder eine runde Form aufweisen, wenn anstoßende Flächen (42) der jeweiligen magnetischen Körper (40) gegeneinander anstoßen, und wobei das Paar magnetischer Körper (40) eine zylindrische Form oder eine runde Form in einem geschlossenen Zustand aufweist, wobei die Aussparungen (21) angeordnet sind, um einander in einem Zustand gegenüber zu liegen, in dem die Aussparungen (21) die jeweiligen magnetischen Körper (40) aufnehmen;
mindestens ein Paar von eingreifendem Abschnitt (28) und eingegriffenem Abschnitt (27), bereitgestellt auf jedem des Paars von Aufnahmeeinheiten (20) wobei das Zentrum der zylindrischen Form oder der runden Form des Paars von magnetischen Körpers (40) zwischen dem eingreifenden Abschnitt (28) und dem eingegriffenen Abschnitt (27) gelegt ist, wobei der eingreifende Abschnitt (28) und der eingegriffene Abschnitt (27) im geschlossenen Zustand ineinander eingreifen, während sie sich elastisch verformen; und
ein Paar Metallfedern (60), die in den jeweiligen Aussparungen (21) bereitgestellt sind, wobei das Paar Metallfedern (60) jeden magnetischen Körper (40) in eine Richtung zu jeder anstoßenden Fläche (42) drückt,
wobei jede des Paars von Metallfedern (60) Folgendes einschließt:
einen flachen Oberflächenabschnitt (61) mit einer rechtwinkligen Form und angeordnet auf einer unteren Fläche der Aussparung (21) der Aufnahmeeinheit (20), und ein Paar geneigter Abschnitte (62), die mit einem Paar langer Seiten des flachen Oberflächenabschnitts (61) kontinuierlich und hin zum magnetischen Körper (40) gebogen sind,
wobei jede des Paars von Metallfedern (60) zwischen den magnetischen Körper (40) und die Aufnahmeeinheit (20) gelegt ist und an Positionen auf der unteren Fläche der Aussparung (21) bereitgestellt ist, die einander in einer Richtung senkrecht zur anstoßenden Fläche (42) gegenüber liegen, wobei die anstoßende Fläche (42) in der geschlossenen Position dazwischen gelegt ist,
wobei der flache Oberflächenabschnitt (61) ein Paar Löcher (65) umfasst, um in ein Paar Vorsprünge (21A) gepasst zu werden, die auf der unteren Oberfläche der Aussparung (21) gebildet sind,
wobei der flache Oberflächenabschnitt (61) die rechtwinklige Form aufweist, wobei sich ein Paar langer Seiten in eine Richtung erstreckt, die eine zentrale Achse des magnetischen Körpers (40) auf der unteren Oberfläche der Aussparung (21) quert, und
wobei das Paar geneigter Abschnitte (62) kontinuierlich mit dem Paar langer Seiten des flachen Oberflächenabschnitts (61) ist und sich in eine Richtung hin zum magnetischen Körper erstreckt und hin zum magnetischen Körper (40) auf den langen Seiten abgewinkelt ist.

2. Halter (20, 60) für einen Stromrauschabsorber (1) nach Anspruch 1, wobei
jeder eingreifende Abschnitt (28) in einer Hakenform gebildet ist, die in eine Richtung senkrecht zur anstoßenden Oberfläche (42) vorspringt, und
jeder eingegriffene Abschnitt (27) als ein torförmiger Stopperrahmen gebildet ist, mit dem der hakenförmige Eingriffsabschnitt (28) eingreift.

3. Halter (20, 60) für einen Stromrauschabsorber (1) nach einem der Ansprüche 1 bis 2, wobei
das Paar Metallfedern (60) aus einem Metall mit einem Widerstand von 10⁻⁷ Ω.m oder mehr gebildet ist.

4. Halter (20, 60) für einen Stromrauschabsorber (1) nach einem der Ansprüche 1 bis 3, wobei
das Paar Aufnahmeeinheiten (20) die gleiche Form aufweist und
das Paar Metallfedern (60) die gleiche Form aufweist.

5. Halter (20, 60) für einen Stromrauschabsorber (1) nach einem der Ansprüche 1 bis 4, weiter umfassend
eine Stütze (36, 37), die auf jedem äußeren Umfang des Paars von Aufnahmeeinheiten (20) bereitgestellt ist, wobei die Stütze (36, 37) verwendet wird, um das Paar Aufnahmeeinheiten (20) und das Paar magnetischer Körper (40) auf einer Fläche parallel zur anstoßenden Fläche (42) anzuordnen.

6. Halter (20, 60) für einen Stromrauschabsorber (1) nach einem der Ansprüche 5 - 6, weiter umfassend als Stütze (36, 37) eine untere Oberfläche (36) der Aufnahmeeinheit (20), wobei die untere Oberfläche (36) eine rechtwinklige Form aufweist, wie im Allgemeinen in einer Draufsicht zu sehen, und die untere Oberfläche (36) eine rechtwinklige Form mit einem Paar langer Seiten parallel zu einer Richtung einer zentralen Achse des magnetischen Körpers (40) auf dem äußeren Umfang des Halters (20) aufweist,
wobei der Halter (20, 60) ein Paar Rippen (37) umfasst, die gebildet sind, um entlang jeder langen Seite der unteren Oberfläche (36) voneinander beabstandet zu sein und entlang einer Erweiterungsebene der unteren Oberfläche (36) vorzuspringen,
wobei das Paar Rippen (37) voneinander in der Richtung von vorne nach hinten beabstandet ist, wobei die untere Oberfläche (36) dazwischen gelegt ist, und jedem des Paars von langen Seiten der unteren Oberfläche (36), die einander gegenüberliegen, benachbart sind,
wobei sich das Paar Rippen (37) entlang der Erweiterungsrichtung in einer einander gegenüberliegenden Richtung vom Paar langer Seiten der unteren Oberfläche (36) erstreckt.

7. Halter (20, 60) für einen Stromrauschabsorber (1) nach einem der Ansprüche 1 bis 6, wobei
jede des Paars von Metallfedern (60) ein Paar zurückgefaltener Abschnitte (63) einschließt, die durch Zurückfalten von Spitzenabschnitten der geneigten Abschnitte (62) in eine Richtung weg vom magnetischen Körper (40) gebildet sind.

8. Stromrauschabsorber (1), umfassend:
ein Paar magnetischer Körper (40), wobei die magnetischen Körper (40) eine zylindrische Form oder eine runde Form aufweisen, wenn anstoßende Oberflächen (42) der jeweiligen magnetischen Körper (40) gegeneinander anstoßen;
ein Paar Aufnahmeeinheiten (20), wobei die Aufnahmeeinheiten jeweilige Aussparungen (21) einschließen, wobei jede Aussparung (21) dazu in der Lage ist, jeden eines Paars von magnetischen Körpern (40) aufzunehmen, und das Paar magnetischer Körper (40) in einem geschlossenen Zustand eine zylindrische Form oder eine runde Form aufweist, wobei die Aussparungen (21) angeordnet sind, um einander in einem Zustand gegenüber zu liegen, in dem die Aussparungen (21) die jeweiligen magnetischen Körper (40) aufnehmen;
mindestens ein Paar von eingreifendem Abschnitt (28) und eingegriffenem Abschnitt (27), bereitgestellt auf jedem des Paars von Aufnahmeeinheiten (20), wobei das Zentrum der zylindrischen Form oder der runden Form des Paars von magnetischen Körpern (40) zwischen den eingreifenden Abschnitt (28) und den eingegriffenen Abschnitt (27) gelegt ist, wobei der eingreifende Abschnitt (28) und der eingegriffene Abschnitt (27) im geschlossenen Zustand ineinander eingreifen, während sie sich elastisch verformen; und
ein Paar Metallfedern (60) in jeder Aussparung (21) bereitgestellt ist, wobei das Paar Metallfedern (60) jeden magnetischen Körper (40) in eine Richtung zu jeder anstoßenden Oberfläche (42) drückt,
wobei jedes Paar Metallfedern (60) einen flachen Oberflächenabschnitt (61) mit einer rechtwinkligen Form aufweist und auf einer unteren Oberfläche der Aussparung (21) der Aufnahmeeinheit (20) angeordnet ist und ein Paar geneigter Abschnitte (62), die mit einem Paar langer Seiten des flachen Oberflächenabschnitts (61) kontinuierlich und hin zum magnetischen Körper (40) gebogen sind,
wobei jedes Paar Metallfedern (60) zwischen den magnetischen Körper (40) und die Aufnahmeeinheit (20) gelegt ist und an Positionen auf der unteren Oberfläche der jeweiligen Aussparungen (21) bereitgestellt ist, die einander in einer Richtung senkrecht zur anstoßenden Oberfläche (42) gegenüber liegen, wobei die anstoßende Fläche (42) in der geschlossenen Position dazwischen gelegt ist,
wobei der flache Oberflächenabschnitt (61) ein Paar Löcher (65) umfasst, um in ein Paar Vorsprünge (21A) gepasst zu werden, die auf einer unteren Oberfläche der Aussparung (21) gebildet sind,
wobei der flache Oberflächenabschnitt (61) eine rechtwinklige Form aufweist, mit einem Paar langer Seiten die sich in eine Richtung erstrecken, die eine zentrale Achse des magnetischen Körpers (40) auf der unteren Oberfläche der Aussparung (21) quert, und
wobei das Paar geneigter Abschnitte (62) mit einem Paar langer Seiten des flachen Oberflächenabschnitts (61) kontinuierlich ist und sich in eine Richtung hin zum magnetischen Körper erstreckt und hin zum magnetischen Körper (40) auf den langen Seiten abgewinkelt ist.

9. Stromrauschabsorber (1) nach Anspruch 8, wobei
das Paar Aufnahmeeinheiten (20) die gleiche Form aufweist,
das Paar magnetischer Körper (40), das im Paar Aufnahmeeinheiten (20) aufgenommen ist, die gleiche Form aufweist, und
das Paar Metallfedern (60) das im Paar Aufnahmeeinheiten (20) aufgenommen ist, die gleiche Form aufweist.

10. Stromrauschabsorber (1) nach einem der Ansprüche 8 bis 9, weiter umfassend
eine Stütze (36, 37), die auf jedem äußeren Umfang des Paars von Aufnahmeeinheiten (20) bereitgestellt ist, wobei die Stütze (36, 37) verwendet wird, um das Paar Aufnahmeeinheiten (20) und das Paar magnetischer Körper (40) auf einer flachen Oberfläche anzuordnen, wobei
Anstoßabschnitte des Paars von magnetischen Körpern (40), die gegen die jeweiligen Metallfedern (60) anstoßen, jeweils als eine flache Oberfläche ungefähr parallel zur flachen Oberfläche gebildet sind.

11. Stromrauschabsorber (1) nach einem der Ansprüche 8 bis 10, wobei
das Paar magnetischer Körper (40) jeweils eine Nut (44) in einer seitlichen Oberfläche davon aufweist, und
das Paar Aufnahmeeinheiten (20) jeweils einen Vorsprung (35) umfasst, der an einer Position der Aussparung (21) gebildet ist, die der Nut (44) des magnetischen Körpers (40) gegenüberliegt.

## Revendications

1. Support (20, 60) destiné à un absorbeur de courant de bruit (1), comprenant :
une paire d'unités de logement (20), les unités de logement comprenant des renfoncements respectifs (21), chaque renfoncement (21) pouvant contenir chacun d'une paire de corps magnétiques (40), les corps magnétiques (40) présentant une forme cylindrique ou une forme annulaire lorsque les surfaces de butée (42) des corps magnétiques respectifs (40) butent les unes contre les autres, et la paire de corps magnétiques (40) présentant une forme cylindrique ou une forme annulaire dans une condition fermée dans laquelle les renfoncements (21) sont prévus pour se faire face dans un état dans lequel les renfoncements (21) contiennent les corps magnétiques respectifs (40) ;
au moins une paire d'une partie d'engagement (28) et d'une partie engagée (27) prévue sur chacune de la paire d'unités de logement (20) avec le centre de la forme cylindrique ou de la forme annulaire de la paire de corps magnétiques (40) interposé entre la partie d'engagement (28) et la partie engagée (27), la partie d'engagement (28) et la partie engagée (27) s'engageant l'une avec l'autre tout en se déformant élastiquement dans la condition fermée ; et
une paire de ressorts métalliques (60) prévue dans les renfoncements respectifs (21), la paire de ressorts métalliques (60) forçant chaque corps magnétique (40) dans une direction qui va vers chaque surface de butée (42),
dans lequel chacun de la paire de ressorts métalliques (60) comprend :
une partie de surface plane (61) ayant une forme rectangulaire et prévue sur une surface inférieure du renfoncement (21) de l'unité de logement (20), et une paire de parties inclinées (62) continues avec une paire de côtés longs de la partie de surface plane (61) et courbées vers le corps magnétique (40),
dans lequel chacun de la paire de ressorts métalliques (60) est interposé entre le corps magnétique (40) et l'unité de logement (20), et est prévu à des emplacements, sur la surface inférieure du renfoncement (21), qui sont opposés les uns aux autres dans une direction normale par rapport à la surface de butée (42) avec la surface de butée (42) interposée entre ceux-ci dans la condition fermée,
dans lequel la partie de surface plane (61) comprend une paire d'orifices (65) à placer sur une paire de saillies (21A) formées sur la surface inférieure du renfoncement (21),
dans lequel la partie de surface plane (61) possède la forme rectangulaire avec une paire de côtés longs qui s'étendent dans une direction qui croise un axe central du corps magnétique (40) sur la surface inférieure du renfoncement (21), et
dans lequel la paire de parties inclinées (62) est continue avec la paire de côtés longs de la partie de surface plane (61) et s'étend dans une direction qui va vers le corps magnétique, et est inclinée vers le corps magnétique (40) sur les côtés longs.

2. Support (20, 60) destiné à un absorbeur de courant de bruit (1) selon la revendication 1, dans lequel
chaque partie d'engagement (28) est formée en forme de crochet qui se projette dans une direction perpendiculaire à la surface de butée (42), et
chaque partie engagée (27) est formée comme une structure de butée en forme de barrière avec laquelle la partie d'engagement en forme de crochet (28) s'engage.

3. Support (20, 60) destiné à un absorbeur de courant de bruit (1) selon l'une quelconque des revendications 1 à 2, dans lequel
la paire de ressorts métalliques (60) est formée par un matériau qui présentent une résistivité de 10⁻⁷ Ω m ou plus.

4. Support (20, 60) destiné à un absorbeur de courant de bruit (1) selon l'une quelconque des revendications 1 à 3, dans lequel
la paire d'unités de logement (20) possède la même forme, et
la paire de ressorts métalliques (60) possède la même forme.

5. Support (20, 60) destiné à un absorbeur de courant de bruit (1) selon l'une quelconque des revendications 1 à 4, comprenant en outre
un support (36, 37) prévu sur chaque périphérie externe de la paire d'unités de logement (20), le support (36, 37) étant utilisé pour disposer la paire d'unités de logement (20) et la paire de corps magnétiques (40) sur une surface parallèle à la surface de butée (42).

6. Support (20, 60) destiné à un absorbeur de courant de bruit (1) selon la revendication 5, comprenant, en guise de support (36, 37),
une surface inférieure (36) de l'unité de logement (20), la surface inférieure (36) ayant une forme rectangulaire lorsqu'elle est vue de dessus d'une manière générale, et la surface inférieure (36) ayant une forme rectangulaire avec une paire de côtés longs parallèles à une direction d'un axe central du corps magnétique (40) sur la périphérie externe du support (20),
dans lequel le support (20, 60) comprend une paire de nervures (37) formées pour être espacées les unes des autres le long de chaque côté long de la surface inférieure (36) et qui se projettent le long d'un plan d'extension de la surface inférieure (36),
dans lequel les deux nervures (37) sont espacées l'une de l'autre dans une direction avant/arrière avec la surface inférieure (36) interposée entre celles-ci, et sont adjacentes à chacun de la paire de côtés longs de la surface inférieure (36) en se faisant face,
dans lequel la paire de nervures (37) s'étend le long du plan d'extension dans une direction opposée l'une à l'autre depuis la paire de côtés longs de la surface inférieure (36).

7. Support (20, 60) destiné à un absorbeur de courant de bruit (1) selon l'une des revendications 1 à 6, dans lequel
chacun de la paire de ressorts métalliques (60) comprend une paire de parties repliées (63) formées en repliant les parties d'extrémité des parties inclinées (62) dans une direction qui s'éloigne du corps magnétique (40).

8. Absorbeur de courant de bruit (1) comprenant :
une paire de corps magnétiques (40), les corps magnétiques (40) présentant une forme cylindrique ou une forme rectangulaire lorsque les surfaces de butée (42) des corps magnétiques respectifs (40) butent les unes contre les autres ;
une paire d'unités de logement (20), les unités de logement comprenant des renfoncements respectifs (21), chaque renfoncement (21) pouvant contenir chacun d'une paire de corps magnétiques (40), les corps magnétiques (40) présentant une forme cylindrique ou une forme annulaire dans une condition fermée dans laquelle les renfoncements (21) sont prévus pour se faire face dans un état dans lequel les renfoncements (21) contiennent les corps magnétiques respectifs (40) ;
au moins une paire d'une partie d'engagement (28) et d'une partie engagée (27) prévue sur chacune de la paire d'unités de logement (20) avec le centre de la forme cylindrique ou de la forme annulaire de la paire de corps magnétiques (40) interposé entre la partie d'engagement (28) et la partie engagée (27), la partie d'engagement (28) et la partie engagée (27), la partie d'engagement (28) et la partie engagée (27) s'engageant l'une avec l'autre tout en se déformant élastiquement dans la condition fermée ; et
une paire de ressorts métalliques (60) prévue dans chaque renfoncement (21), la paire de ressorts métalliques (60) forçant chaque corps magnétique (40) dans une direction qui va vers chaque surface de butée (42),
dans lequel chacun de la paire de ressorts métalliques (60) comprend une partie de surface plane (61) ayant une forme rectangulaire et prévue sur une surface inférieure du renfoncement (21) de l'unité de logement (20), et une paire de parties inclinées (62) continues avec une paire de côtés longs de la partie de surface plane (61) et courbées vers le corps magnétique (40),
dans lequel chacun de la paire de ressorts métalliques (60) est interposé entre le corps magnétique (40) et l'unité de logement (20), et est prévu à des emplacements, sur la surface inférieure des renfoncements respectifs (21), qui sont opposés les uns aux autres dans une direction normale par rapport à la surface de butée (42) avec la surface de butée (42) interposée entre ceux-ci dans la condition fermée,
dans lequel la partie de surface plane (61) comprend une paire d'orifices (65) à placer sur une paire de saillies (21A) formées sur la surface inférieure du renfoncement (21),
dans lequel la partie de surface plane (61) possède la forme rectangulaire avec une paire de côtés longs qui s'étendent dans une direction qui croise un axe central du corps magnétique (40) sur la surface inférieure du renfoncement (21), et
dans lequel la paire de parties inclinées (62) est continue avec la paire de côtés longs de la partie de surface plane (61) et s'étend dans une direction qui va vers le corps magnétique, et est inclinée vers le corps magnétique (40) sur les côtés longs.

9. Absorbeur de courant de bruit (1) selon la revendication 8, dans lequel
la paire d'unités de logement (20) possède la même forme,
la paire de corps magnétiques (40) contenue dans la paire d'unités de logement (20) possède la même forme, et
la paire de ressorts métalliques (60) contenue dans la paire d'unités de logement (20) possède la même forme.

10. Absorbeur de courant de bruit (1) selon la revendication 8 ou 9, comprenant en outre
un support (36, 37) prévu sur chaque périphérie externe de la paire d'unités de logement (20), le support (36, 37) étant utilisé pour disposer la paire d'unités de logement (20) et la paire de corps magnétiques (40) sur une surface plane,
dans lequel
les parties de butée de la paire de corps magnétiques (40) qui butent contre les ressorts métalliques respectifs (60) sont chacune formées comme une surface plane approximativement parallèle à la surface plane.

11. Absorbeur de courant de bruit (1) selon l'une quelconque des revendications 8 à 10, dans lequel
les deux corps magnétiques (40) possèdent chacun une rainure (44) dans une surface latérale de ceux-ci,
et
les deux unités de logement (20) comprennent chacune une saillie (35) formée à un emplacement sur le renfoncement (21) opposé à la rainure (44) du corps magnétique (40).
